# EUROPEAN PATENT APPLICATION

(11) **EP 3 757 585 A1**
(43) Date of publication of application: **30.12.2020**
(21) Application number: 19305880.7
(22) Date of filing: 28.06.2019
(51) Int. Cl.: G01R 31/26, G01R 31/28, H01L 23/00

(54) **AN APPARATUS COMPRISING A DEFECT SENSOR STRUCTURE**

(71) Applicant: NXP USA, Inc., Austin TX 78735 (US)
(72) Inventor: Poeton, Laurence, 31023 Toulouse cedex 1 (FR); Savatier, Nicolas, 31023 Toulouse cedex 1 (FR)
(74) Representative: Miles, John Richard

(57) **Abstract**

An apparatus comprising: a substrate; an integrated circuit region; a seal ring; a first defect sensor structure comprising a first conductive track formed in the substrate arranged to extend along a first edge of the substrate wherein the first conductive track comprises: a first upper conductive track part; a first lower conductive track part; and a first connecting track arranged to electrically connect the first upper conductive track part to the first lower conductive track part, and the first defect sensor structure further comprises: a first terminal coupled to the first upper conductive track part; and a second terminal coupled to the first lower conductive track part, the first defect sensor structure configured to receive a detection signal therethrough between the first terminal and the second terminal to detect a break in the conductive track between said first and second terminals and thereby detect a defect in the substrate.

## Description

### Field

The present disclosure relates to an apparatus comprising a substrate and an integrated circuit region and having a defect sensor structure comprising a conductive track formed in the substrate and extending along at least a first edge of the substrate. It also relates to a semiconductor die and an associated method of testing for defects in an apparatus.

### Summary

According to a first aspect, there is provided an apparatus comprising:
a substrate;
an integrated circuit region formed in the substrate;
a seal ring disposed in the substrate to form a ring around the integrated circuit region;
a first defect sensor structure comprising a first conductive track formed in the substrate, the first conductive track arranged to extend along a first edge of the substrate and disposed between the integrated circuit region and the seal ring wherein the first conductive track comprises:
   a first upper conductive track part formed in the substrate;
   a first lower conductive track part formed in the substrate below the first upper conductive track part; and
   a first connecting track arranged to electrically connect the first upper conductive track part to the first lower conductive track part,
and the first defect sensor structure further comprises:
   a first terminal coupled to the first upper conductive track part; and
   a second terminal coupled to the first lower conductive track part,
the first defect sensor structure configured to receive a detection signal therethrough between the first terminal and the second terminal to detect a break in the conductive track between said first and second terminals and thereby detect a defect in the substrate.

In one or more embodiments, the first upper conductive track part and the first lower conductive track part may each comprise a first end and a second end, wherein the first ends are located substantially adjacent one another and the second ends are located substantially adjacent one another, and wherein the first terminal may be located at the first end of the first upper conductive track part and the second terminal may be located at the first end of the lower conductive track part and the first connecting track may be arranged to electrically connect the respective second ends.

In one or more embodiments, the first connecting track may comprise a via.

In one or more embodiments, the track parts may be electrically isolated from one another along their length other than at the first connecting track.

In one or more embodiments, the first defect sensor structure may comprise a second conductive track formed in the substrate, the second conductive track arranged to extend along a second edge of the substrate, different to first edge, and disposed between the integrated circuit region and the seal ring wherein the second conductive track may comprise:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part and the second lower conductive track part, wherein one of:
   the first terminal may be coupled to the second upper conductive track part at the first end thereof and a third terminal, different to the second terminal, may be coupled to the first end of the second lower conductive track part;
   the second terminal may be coupled to the second lower conductive track part at the first end thereof and the third terminal, different to the first terminal, may be coupled to the first end of the second upper conductive track part; and
   the first terminal may be coupled to the second lower conductive track part at the first end thereof and the third terminal, different to the second terminal, may be coupled to the first end of the second upper conductive track part.

In one or more embodiments, the first defect sensor structure may comprise a second conductive track formed in the substrate, the second conductive track arranged to extend along a different portion of the first edge to the first conductive track, the second conductive track disposed between the integrated circuit region and the seal ring wherein the second conductive track may comprise:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part to the second lower conductive track part, wherein one of:
   the first terminal may be coupled to the second upper conductive track part at the first end thereof and a third terminal, different to the second terminal, may be coupled to the first end of the second lower conductive track part;
   the second terminal may be coupled to the second lower conductive track part at the first end thereof and the third terminal, different to the first terminal, may be coupled to the first end of the second upper conductive track part; and
   the first terminal may be coupled to the second lower conductive track part at the first end thereof and the third terminal, different to the second terminal, may be coupled to the first end of the second upper conductive track part.

In one or more embodiments, the third terminal may be arranged in a group with the first and second terminals, wherein the first, second and third terminals are adjacent to one another.

In one or more embodiments, the first terminal may be arranged substantially at a first corner of the substrate and the first connecting track may be arranged substantially at a second corner of the substrate, different from the first corner, such that the first upper conductive track part extends along the first edge of the substrate between the first and second corners.

In one or more embodiments, the apparatus may comprises at least a second defect sensor structure, the at least second defect sensor structure may comprising at least a first conductive track formed in the substrate, the first conductive track of the at least second defect sensor structure arranged to extend along an edge of the substrate and disposed between the integrated circuit region and the seal ring wherein the first conductive track of the at least second defect sensor structure may comprise:
a first upper conductive track part formed in the substrate and having a first end and a second end;
a first lower conductive track part formed in the substrate below the first upper conductive track part and having a first end and a second end; and
a first connecting track arranged to electrically connect the second ends of the first upper conductive track part to the first lower conductive track part,
and the at least second defect sensor structure may further comprise:
a first terminal coupled to the first end of the first upper conductive track part; and
a second terminal coupled to the first end of the first lower conductive track part,
the at least second defect sensor structure configured to receive a detection signal therethrough between its first terminal and its second terminal to detect a break in the conductive track between said first and second terminals and thereby detect a defect in the substrate.

In one or more embodiments, the second defect sensor structure may further comprise a second conductive track formed in the substrate, the second conductive track arranged to extend along an edge of the substrate different to the edge along which the first conductive track of the second defect sensor structure extends, and disposed between the integrated circuit region and the seal ring wherein the second conductive track of the at least second defect sensor structure may comprise:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part and the second lower conductive track part,
wherein one of:
the first terminal of the at least second defect sensor structure may be coupled to the second upper conductive track part at the first end thereof and a third terminal, different to the second terminal, may be coupled to the first end of the second lower conductive track part;
the second terminal of the at least second defect sensor structure may be coupled to the second lower conductive track part at the first end thereof and the third terminal, different to the first terminal, may be coupled to the first end of the second upper conductive track part; and
the first terminal of the at least second defect sensor structure may be coupled to the second lower conductive track part at the first end thereof and the third terminal, different to the second terminal, may be coupled to the first end of the second upper conductive track part.

In one or more embodiments, the first conductive track of the second defect sensor structure may be arranged to extend along the first edge of the substrate and the second defect sensor structure may be vertically arranged in the substrate below the first defect sensor structure such that the first defect sensor structure and the second defect sensor structure form a vertical stack in the substrate.

In one or more embodiments, the first conductive track of the second defect sensor structure may be arranged to extend along a different portion of the first edge to the first conductive track, such that the position of a defect along the first edge of the substrate can be detected by the identification of which of the first defect sensor structure and the second defect sensor structure has detected a defect.

In one or more embodiments, the first conductive track of the second defect sensor structure may extend along a third edge of the substrate different to the first edge or the second edge of the substrate.

In one or more embodiment, the first terminal of the first defect sensor structure may be located at a different corner of the substrate to the first terminal of the second defect sensor structure.

In one or more embodiments, the first defect sensor structure and the second defect sensor structure may be arranged such that the first and second conductive tracks of the first and second defect sensor structures extend along different edges of the substrate to one another.

In one or more embodiments, the substrate may be a wafer and at least the integrated circuit region, the seal ring and the first defect sensor structure may provide a semiconductor arrangement formed in the substrate and wherein the substrate may comprise a plurality of such semiconductor arrangements, each of the plurality of semiconductor arrangements spaced from one another, and wherein, for each semiconductor arrangement, the edges of the substrate refer to the edge portions of the substrate bounded by the seal ring of the respective semiconductor arrangement.

According to a second aspect, there is provided a method of testing an apparatus for faults, the apparatus comprising:
a substrate;
an integrated circuit region formed in the substrate;
a seal ring disposed in the substrate to form a ring around the integrated circuit region;
a first defect sensor structure comprising a first conductive track formed in the substrate, the first conductive track arranged to extend along a first edge of the substrate and disposed between the integrated circuit region and the seal ring wherein the first conductive track comprises:
   a first upper conductive track part formed in the substrate;
   a first lower conductive track part formed in the substrate below the first upper conductive track part; and
   a first connecting track which electrically connects the first upper conductive track part to the first lower conductive track part,
   and the first defect sensor structure further comprises:
   a first terminal coupled to the first upper conductive track part; and
   a second terminal coupled to the first lower conductive track part,
and wherein testing comprises:
applying the detection signal to one of the first terminal and the second terminal;
determining the absence of a fault along the first conductive track based on the electrical continuity of the first conductive track; and
determining the presence of a fault along the first conductive track based on a lack of electrical continuity of the first conductive track.

In one or more embodiments, the first upper conductive track part and the first lower conductive track part may each comprise a first end and a second end, wherein the first ends are located substantially adjacent to one another and the second ends are located substantially adjacent one another, and wherein the first terminal may be located at the first end of the first upper conductive track part and the second terminal may be located at the first end of the lower conductive track part and the second terminal may be located at the first end of the lower conductive track part and the first connecting track may be arranged to electrically connect the respective second ends and wherein the first defect sensor structure may further comprise:
a second conductive track formed in the substrate, the second conductive track arranged to extend along a second edge of the substrate, different to first edge, and disposed between the integrated circuit region and the seal ring wherein the second conductive track may comprise:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part and the second lower conductive track part,
wherein one of:
the first terminal may be coupled to the second upper conductive track part at the first end thereof and a third terminal, different to the second terminal, may be coupled to the first end of the second lower conductive track part and wherein testing the apparatus may comprise applying the detection signal to the first terminal;
the second terminal may be coupled to the second lower conductive track part at the first end thereof and the third terminal, different to the first terminal, may be coupled to the first end of the second upper conductive track part and wherein testing the apparatus may comprise applying the detection signal to the second terminal; and
the first terminal may be coupled to the second lower conductive track part at the first end thereof and the third terminal, different to the second terminal, may be coupled to the first end of the second upper conductive track part and wherein testing the apparatus may comprise applying the detection signal to the first terminal, and testing the apparatus may further comprise:
   determining the absence of a fault along the second conductive track based on the electrical continuity of the second conductive track, and
   determining the presence of a fault along the second conductive track based on a lack of electrical continuity of the second conductive track.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The Figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an apparatus comprising first and second defect sensor structures;
Figure 2 shows an example embodiment of a plurality of vertically stacked defect sensor structures;
Figure 3 shows an example embodiment of an apparatus comprising a plurality of arrangements;
Figure 4 shows an example flowchart illustrating a method of testing an apparatus for defects using a defect sensor structure; and
Figure 5 shows example testing circuitry.

### Detailed Description

During integrated circuit manufacture, integrated circuit components are formed on a substrate, termed a wafer. Typically, many individual integrated circuit arrangements are formed on the wafer and one or more or each are delimited by a seal ring, which may otherwise be referred to as a scribe seal. The wafer is then diced around the seal ring, such as by cutting or sawing, to form the individual integrated circuit arrangements. The integrated circuit arrangements may comprise dies or chip scale packages (CSP) depending on the type of integrated circuit being manufactured. During dicing of the wafer into separate dies or CSPs there is a small chance of chipping and/or crack formation due to dicing blade stress, for example.

Integrated circuit arrangements are typically provided with a seal ring that extends partially or fully around the outer periphery of the integrated circuit arrangement. The seal ring is typically a continuous ring of one or more metal layers. In one or more examples, the metal layers are connected by vias, such as a ring of vias or a continuous ring of vias. In one or more examples, the metal layers comprise one or more of Copper or Aluminium metallization and vias in the substrate configured to provide a hermetic seal between the outside environment and the dielectric layers of the integrated circuit formed in the semiconductor substrate. The seal ring may have one or more of the following functions: to provide for protection against moisture ingress to integrated circuit components formed in the substrate of the integrated circuit arrangement; to provide for protection against ion ingress to integrated circuit components formed in the substrate; and provide a structure to protect against the propagation of cracks in the substrate typically towards a region inwardly of the seal ring where the integrated circuit components are located.

In the examples that follow, an apparatus is disclosed which comprises a defect sensor structure configured to allow for the detection of defects that indicate that the seal ring has failed. Such defects may include cracks in, or chipping of, the substrate or die delamination. Indication of failure is detected preferably before defects propagate through the substrate and reach the integrated circuit region. This apparatus may thereby potentially provide for better detection of potential issues and provide improved reliability in the final apparatus. In one or more embodiments, the defect sensor structure may allow for the determination of the location of defects, thereby allowing for the identification of areas of a wafer which, after processing, are regularly resulting in faults and thereby the defect sensor structure allows for diagnosis of faulty manufacturing or processing equipment or processes.

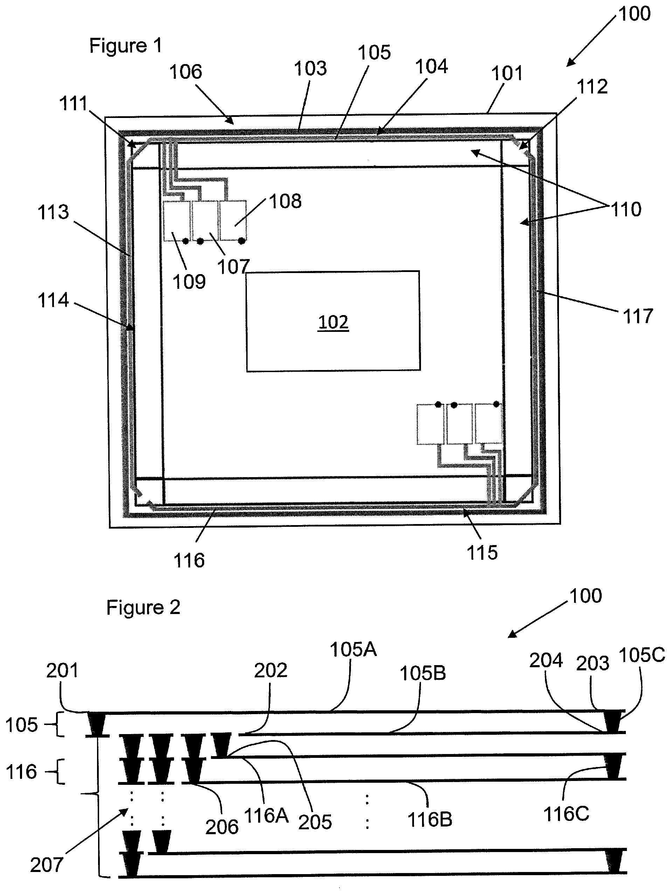

Figure 1 shows an apparatus 100 comprising a substrate 101 having an integrated circuit region 102 formed therein. The substrate 101 may comprise any suitable semiconductor material such as, but not limited to, crystalline silicon, germanium, gallium arsenide, gallium nitride or silicon carbide.

The integrated circuit region 102 may include one or more integrated circuit components, such as one or more of transistors; capacitors; inductors; and resistors together configured to perform a desired function.

The apparatus 100 further comprises a seal ring 103 disposed in the substrate 101 and forms a closed ring around the integrated circuit region 102. When the apparatus 100 is diced from the wafer, the seal ring 103 may be used as a guide around which a dicing apparatus, such as a saw, separates the wafer into individual apparatuses.

The seal ring 103 may be configured to provide for protection against one or more of moisture; ion ingress to the integrated circuit region; crack or defect propagation through the substrate. Thus, the seal ring 103, which comprises a portion of the substrate 101 defined by one or more of metal layers, diffusion layers and vias extending therethrough, may provide a barrier against propagation of cracks towards the integrated circuit region 102. Nevertheless, cracks and other defects may, in some circumstances, breach the seal ring 103 and thus impact on the functionality of the integrated circuit region 102.

The apparatus 100 further comprises a first defect sensor structure 104 comprising a first conductive track 105 formed in the substrate 101 and arranged to extend along a first edge 106 of the substrate 101, such as adjacent to but spaced inwardly of the first edge. The first edge 106 may comprise an edge of the substrate 101 after dicing or a region of the substrate 101 that will become an edge when the substrate is diced at a later time. If the substrate 101 is damaged at a point on an edge of the substrate along which a first conductive track 105 of the defect sensor structure 104 extends, the first conductive track 105 will be damaged. Damage to the first conductive track 105 of the first defect sensor structure 104 may prevent a current flowing from a first terminal 107 at a first point along the first conductive track 105 to a second terminal 108 at a second point along the first conductive track 105. The first and second terminals may comprise part of the integrated circuit region 102 or may be formed elsewhere in the substrate.

The first conductive track 105 of the first defect sensor is disposed between the integrated circuit region and the seal ring. By situating the defect sensor structure between the seal ring 103 and the integrated circuit region 102, it may be possible to detect substrate defects, such as cracks, before they propagate to the integrated circuit region 102, thereby allowing for early detection of faulty circuit arrangements before failure occurs.

Damage to substrate 101 may be determined by providing a detection signal through the defect sensor structure 104 between the first terminal 107 and the second terminal 108. The terminal which is provided with the detection signal may be referred to as the driving terminal and the terminal which is configured to receive the detection signal from the driving terminal (in the case of no damage) may be referred to as the receiving terminal 108. If the detection signal is applied to the driving terminal and is received at the receiving terminal, then it can be determined that no damage has been caused to the substrate 101 because there is electrical continuity between the first and second terminals. If the detection signal is applied to the driving terminal and is not received at the receiving terminal, it may be determined that a fault exists along the length of the substrate 101 along which the first conductive track 105 extends because there is an absence of electrical continuity between the first and second terminals.

The first terminal 107 and the second terminal 108 may comprise connecting pads to which conductive contacts can be connected or against which conductive contacts can be abutted. The provision of the first terminal 107 and second terminal 108 not only allows for testing of the structural integrity of the substrate 101 after dicing, but also at any other point in time. Testing may be performed by simply electrically connecting a pair of conductive contacts to the first and second terminals 107, 108, providing a detection signal from one of the contacts and determining whether the detection signal is received at the other of the contacts 107, 108. In this way, the apparatus 100 of the present disclosure can be tested for defects throughout its lifetime. In one or more embodiments, the testing is performed by testing circuitry arranged in the substrate 101 of the apparatus 100 wherein the testing circuitry is coupled to the first and second terminals 107, 108. In this way, testing can be performed by applying a detection signal to one of the first and second terminals and determining whether the detection signal is received at the other of the contacts 107, 108.

As depicted in Figure 2, the first conductive track 105 comprises a first upper conductive track part 105A formed in a first layer of the substrate 101 (not shown), a first lower conductive track part 105B formed in a second layer of the substrate 101 lower than the first layer of the substrate 101 and a first connecting track 105C which electrically connects the first upper conductive track part 105A to the first lower conductive track part 105B. It will be appreciated that the use of the terminology "first layer" or "second layer" is not intended to relate to a specific layer of the substrate but simply to demonstrate the different depths at which the conductive track parts extend in the substrate. In some examples, the first upper conductive track part is aligned, over at least part or all of its length, with the first lower conductive track part along the first edge.

The first upper conductive track part 105A may be coupled with the first terminal 107 at a first end 201 of the upper conductive track part 105A. The first lower conductive track part 105B may be coupled with the second terminal 108 at a first end 202 of the lower conductive track part 105B. By way of the first upper conductive track part 105A, the first connecting track 105C and the first lower conductive track part 105B, a portion of the first edge 106 of the substrate 101 is provided with two connected conductive lengths of material, one above the other. By way of this arrangement, a crack, chip or other defect near the first edge 106 of the substrate 101 may cause damage to the first conductive track 105 (at least before the defect spreads to the integrated circuit region 102). It will be appreciated that damage to any one or more of the first upper conductive track part 105A, the first lower conductive track part 105B or the first connecting track 105C may prevent the flow of current from the first terminal 107 to the second terminal 108 and thereby provide an indication of a defect in the substrate. In one or more embodiments, the first connecting track 105C may comprise one or more vias which extend from between the first upper conductive track part 105A and the first lower conductive track part 105B.

The first upper conductive track part 105A and the first lower conductive track part 105B each comprise the first end 201, 202 and a second end 203, 204. In one or more embodiments, the first ends 201, 202 of the first upper conductive track part 105A and first lower conductive track part 105B are located substantially adjacent to one another and the second ends 203, 204 are located substantially adjacent one another. The first terminal 107 is electrically coupled (coupling not shown in Figure 2) to the first end 201 of the first upper conductive track part 105A and the second terminal 108 is electrically coupled (coupling not shown in Figure 2) to the first end 202 of the lower conductive track part 105B. The first terminal 107 may be coupled to the first upper conductive track part 105A and/or the second terminal 108 may be coupled to the first lower conductive track part 105B by way of individual via arrangements depending on which layer(s) of the substrate the first and second terminals are located relative to the conductive track parts. The first connecting track 105C is arranged to electrically couple the respective second ends 203, 204 of the first upper conductive track part 105A and the first lower conductive track part 105B. The second ends 203, 204 of the first upper conductive track part 105A and the first lower conductive track part 105B are arranged distal from the first ends 201, 202. In one or more examples, the first upper conductive track 105A and the first lower conductive track 105B are electrically isolated from one another along their lengths other than at the first connecting track 105C (and when a detection signal is passed between the terminals).

A detection signal can be applied to or passed through the defect sensor 104 by providing a signal at the first terminal 107 and determining whether the detection signal is received at the second terminal 108. If the signal is not received at the second terminal 108, then this may be indicative of damage to the first conductive track 105, for example, it may be indicative of a crack or chip in the substrate 101 somewhere along the length of the conductive track 105. It will be appreciated that, instead, the detection signal may be provided at the second terminal 108 and determination may be made as to whether the detection signal is received at the first terminal 107. In one or more embodiments, the testing circuitry may comprise processing logic that is coupled to the receiving terminal, which may be the first terminal 107 or the second terminal 108, to provide for automated determination of whether or not a fault has occurred upon testing.

Returning to Figure 1, in one or more embodiments, the apparatus may comprise input/output rails 110 which form a loop arranged outside of the integrated circuit region 102. The input/output rails 110 may provide a voltage source and voltage drain to which the electronic components of the integrated circuit region 102 may be coupled. Thus, the input/output rails 110 may be configured to provide a power supply and connection to ground for the IC. The input/output rails 110 may also provide for an input/output interface to components external to the apparatus. In some examples, the first conductive track 105 may be arranged such that it extends between the seal ring 103 and the input/output rails 110. In one or more embodiments, the first conductive track 105 may be arranged to extend between the input/output rails 110 and the integrated circuit region 102. In one or more embodiments, the first conductive track 105 may cross the input/output rails 110 at one or more points along its length.

The first conductive track 105 may extend substantially along a majority of the first edge 106 of the substrate 101, substantially from a first corner region 111 to a second corner region 112. It will be appreciated that the first conductive track 105 may not extend from the tip of one corner to the tip of another corner (i.e. at the meeting of two edges of the substrate) of the substrate 101, but rather it may extend, inwardly spaced from the first edge 106, from a first corner region 111 to a second corner region 112. The first conductive track 105 may extend substantially along the entire length of the first edge 106 while maintaining a predetermined minimum (e.g. non-zero) spacing from the first edge. In one or more embodiments, the first conductive track 105 may only extend part-way along the first edge 106 of the substrate 101. For example, the first conductive track 105 may extend along less than or more than 30 percent, 50 percent, or 70 percent of the length of the first edge 106, for example. The smaller the extent of the conductive track 105 along an edge of the substrate, the more accurate a determination may be of where a defect is present on the substrate 101.

In one or more embodiments, the defect sensor structure 104 may comprise a second conductive track 113 (shown in Figure 1) formed in the substrate 101, the second conductive track 113 disposed between the integrated circuit region 102 and the seal ring 103. The second conductive track 113 may be adjacent to the seal ring 103 and spaced inwardly from an edge along which it extends.

Similar to the first conductive track 105, the second conductive track 113 may comprise a second upper conductive track part formed in the substrate 101, a second lower conductive track part formed in the substrate 101 below the second upper conductive track part and a second connecting track which electrically connects the second upper conductive track part to the second lower conductive track part. In some examples, the second upper conductive track part is aligned, over at least part or all of its length, with the second lower conductive track part along the edge. By way of the second upper conductive track part, the second connecting track and the second lower conductive track part, a portion of an edge of the substrate 101 is provided with two conductive lengths of material, one above the other. By way of this arrangement, a crack, chip or other defect near the corresponding edge of the substrate 101 may cause damage to the second conductive track 113 (at least before the defect spreads to the integrated circuit region 102). It will be appreciated that damage to one or more of the second upper conductive track part, the second lower conductive track part or the second connecting track may prevent the flow of current from the driving terminal (whether that is the first terminal or the second terminal) to the third terminal and thereby provide an indication of a defect in the substrate 101.

The second upper conductive track part and the second lower conductive track part also each comprise a first end and a second end. The first ends of the second upper conductive track part and second lower conductive track part are located substantially adjacent to one another and the second ends are located substantially adjacent one another. The second connecting track is arranged to electrically connect the respective second ends of the second upper conductive track part and the second lower conductive track part. The second ends of the second upper conductive track part and the second lower conductive track part are arranged distal from the first ends. In one or more examples, the second upper conductive track part and the second lower conductive track part are electrically isolated from one another along their lengths other than at the second connecting track (and when a detection signal is passed between the terminals).

In one or more embodiments, the first terminal 107 is located at and coupled with the first end of the second upper conductive track part and a third terminal 109, different to the first and second terminals 107, 108, is coupled to the first end of the second lower conductive track part. In this example, the first terminal 107 is the driving terminal for both the first and second conductive tracks and the second and third terminals 108, 109 are the receiving terminals for the first and second conductive tracks 105, 113, respectively.

In one or more embodiments, the second terminal 108 is coupled to the second lower conductive track part at the first end thereof and the third terminal 109, different to the first and second terminal 107 108, is coupled to the first end of the second upper conductive track part. In this example, the second terminal 108 is the driving terminal and the first and third terminals 107, 109 are the receiving terminals for the first and second conductive tracks 105, 113, respectively.

In one or more embodiments, the first terminal 107 is coupled to the second lower conductive track part at the first end thereof and the third terminal 109, different to the second terminal 108, is coupled to the first end of the second upper conductive track part. In this example, the first terminal 107 is the driving terminal and the second and third terminals 108, 109 are the receiving terminals for the first and second conductive tracks 105, 113, respectively.

In one or more examples, the first and second conductive tracks 105, 113 may extend along different, non-overlapping, portions of the first edge 106 of the substrate 101. In one or more other examples the second conductive track 113 may extend along a second edge 114 of the substrate 101 different to the first edge 106. In either case, by providing a defect sensor structure 104 comprising first and second conductive tracks 105, 113, a common driving terminal and separate receiving terminals, it may be possible to differentiate between a defect positioned along a portion of the substrate 101 along which the first conductive track 105 extends and a defect positioned along a portion of the substrate 101 along which the second conductive track 113 extends. Using a common driving terminal may obviate the need for an additional driving terminal and thereby may reduce the area of the apparatus 100 which needs to be dedicated to defect sensing purposes while improving the diagnostic accuracy of the defect sensor structure 104.

As shown in Figure 1, the apparatus 100 may comprise at least a second defect sensor structure 115. In some examples, the apparatus 100 may comprise a third, fourth, or more defect sensor structures. The third, fourth or more defect sensor structures may be arranged to detect defects at different edges or portions of those edges of the substrate to any of the other defect sensor structures. The at least second defect sensor structure 115 may also comprise at least a first conductive track 116 formed in the substrate 101 of the apparatus 100. The first conductive track 116 of the at least second defect sensor structure 115 may be arranged to extend along an edge of the substrate 101 and may be disposed between the integrated circuit region 102 and the seal ring 103. The second defect sensor structure 115 may also comprise a second conductive track 117 arranged to extend over a different edge of the substrate 101 to the first conductive track 116 of the at least second defect sensor structure 115 or along a different, non-overlapping, portion of the same edge that the first conductive track 116 extends over.

The conductive tracks 116, 117 of the second defect sensor structure 115 may extend substantially along a majority of one or more edges of the substrate 101, substantially from a corner region to a different corner region. It will be appreciated that the first conductive track 116 of the second defect sensor structure 115 may not extend from the tip of one corner to the tip of another corner of the substrate 101, but rather it may extend, inwardly spaced from the first edge 106, from a corner region to a different corner region. The first conductive track 116 may extend substantially along the entire length of the corresponding edge while maintaining a predetermined minimum (e.g. non-zero) spacing from said edge. In one or more embodiments, the first conductive track 116 may only extend part-way along an edge of the substrate 101. For example, the first conductive track may extend along less than or more than 30 percent, 50 percent, or 70 percent of the length of an edge, for example.

One or more additional defect sensor structures, such as the second defect structure 115, may be arranged such that their conductive tracks 116, 117 extend along edge portions of the substrate along which the conductive track or tracks 105, 113 of the first defect sensor structure 104 does not extend. In this way, the presence of defects that occur along different edges of the substrate 101 may be identified and differentiated between. In the example of a quadrangular substrate, the first defect sensor 104 structure and a second defect sensor structure 115 may be employed, where the terminals of the defect sensor structures 104, 115 are located substantially at diagonally opposing corners of the substrate 101 and each defect sensor structure 104, 115 comprises first and second conductive tracks 105, 113, 116, 117 extending along different edges of the substrate 101. In this way, defects arising along any of the four edges of the quadrangular substrate 101 may be detected and differentiated between.

It will be appreciated that, in one or more embodiments, the apparatus 100 may comprise N defect sensor structures where N is the number of edges of the substrate 101 and each defect sensor structure comprises a single conductive track comprised of upper and lower conductive track parts as described above in relation to the first conductive track 105 and the second conductive track extending along one of the edges of the substrate 101. In other examples, the apparatus 100 may comprise N defect sensor structures where N is the number of edges of the substrate 101 and each defect sensor structure comprises two conductive tracks extending substantially half-way along two different edges of the substrate 101. In one or more embodiments, the terminals of a defect sensor structure may be arranged substantially at the centre of an edge of the substrate 101 and the first and second conductive tracks may extend outwardly therefrom such that, the first and second conductive tracks together extend at least partially across an edge of the substrate 101 such that defects on different halves of the edge may be differentiated between. In one or more embodiments, the apparatus 100 may comprise N/2 defect sensors where N is the number of edges of the substrate 101 and each defect sensor structure comprises two conductive tracks, each conductive track configured to extend substantially along the entirety of one edge of the substrate 101. In one or more embodiments, the apparatus 100 may comprise one or more defect sensor structures having a single conductive track and one or more defect sensor structures having two conductive tracks.

Referring back to Figure 2, it will be appreciated that, in embodiments comprising a second defect sensor structure 115, the second defect sensor structure 115 may also comprise a similar structure to that of the first defect sensor structure 104. For example, the second defect sensor structure 115 may comprise a first conductive track 116 having a first upper conductive track part 116A having a first end 205 coupled to a first terminal of the second defect sensor structure 115, a first lower conductive track part 116B having a first end 206 coupled to a second terminal of the defect sensor structure 115, a first connecting track 116C. In examples where the second defect structure 115 comprises a second conductive track 117, that second conductive track may comprise a second upper conductive track, a second lower conductive track, a second connecting track and a third terminal. The constituent components of a second defect sensor structure 115 may have the same structural arrangements and features of the first defect sensor structure 104 described above and any such description of the first defect sensor structure 104 may apply equally to at least a second defect sensor structure 115.

As shown in Figure 2, in some examples the first conductive track 116 of the second defect sensor structure 115 may also be arranged to extend along the first edge of the substrate 101. In this example the second defect sensor structure 115 is vertically arranged (wherein the vertical direction extends normal to the plane of the substrate) in the substrate below the first defect sensor structure such that the first defect sensor structure 104 and the second defect sensor structure 115 are vertically stacked in the substrate. The first defect sensor structure 104 and the second defect sensor structure 115 may be electrically isolated from one another. For example, the defect sensors may be electrically isolated from one another by way of breaks in the conductive tracks, as shown in Figure 2. As such, each of the first and second defect sensor structures may have individual driving and receiving terminals.

If a vertical stack of defect sensor structures detects a defect associated with only one of the first and second defect sensor structures 104, 115, this may be indicative of a chip in the substrate 101 and not a crack which propagates through an extended depth of the substrate 101, such as all the way through the substrate 101. By providing for differentiation between crack and chip formation, a particularly advantageous form of post-defect detection analysis may be provided. By determining the nature of the defect, it may be easier to determine the defect's cause and thereby take steps to reduce such problems arising in subsequently manufactured apparatuses.

It will be appreciated that, as represented by the dots 207 of Figure 2, any number of defect sensor structures may be formed into a vertical stack of defect sensor structures in the substrate 101.

It will be appreciated that, in one or more examples, an apparatus 100 may comprise both a plurality of defect sensor structures arranged to have conductive tracks along different edges to one another, as depicted in Figure 1, and a plurality of defect sensor structures arranged along the same edge in order to form a vertical stack of defect sensor structures.

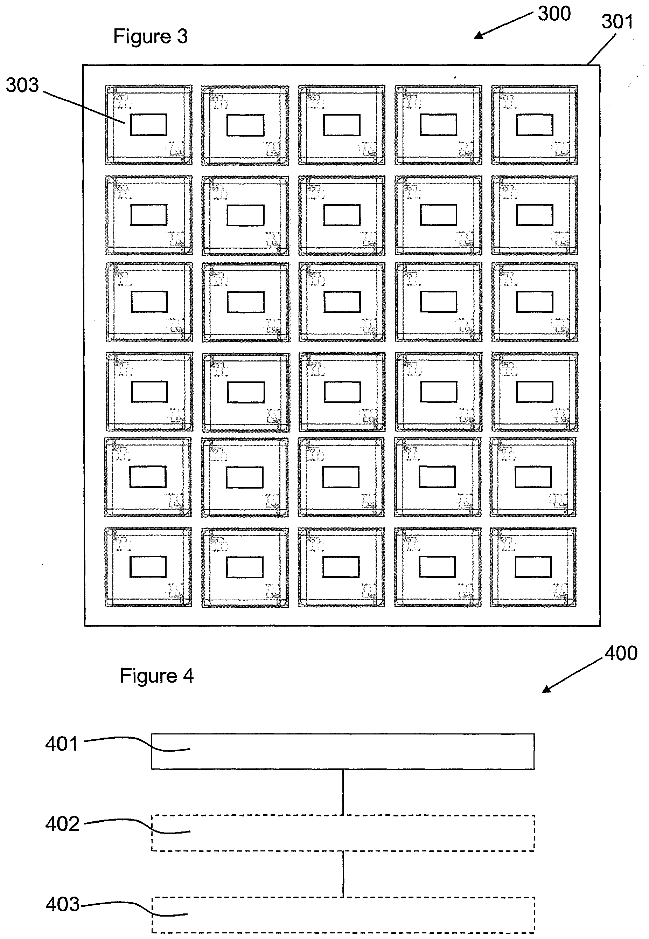

As shown in Figure 3, the substrate 301 may comprise a wafer, such as a semiconductor wafer. At least the integrated circuit region 102, the seal ring 103 and the first defect sensor structure 104 may together provide a semiconductor arrangement 303 formed in the substrate. The substrate 301 may comprise a plurality of such semiconductor arrangements 303, each of the plurality of semiconductor arrangements 303 spaced from one another, and wherein, for each semiconductor arrangement 303, the edges of the substrate 101 refer to the edges that delimit one semiconductor arrangement from another on the substrate. It will be appreciated that the apparatus 300 in this embodiment comprises a plurality of semiconductor arrangements 303 which have not yet been diced or otherwise separated into individual apparatuses 100. It will be appreciated that in one or more embodiments, the semiconductor arrangements 303 of the apparatus will be structurally identical while in one or more embodiments, one or more of the semiconductor arrangements 303 may be structurally different to one another. For example, each semiconductor arrangement 303 may have different sizes, different integrated circuit components formed into their integrated circuit regions or different functionalities.

As shown in Figure 4, there is provided a method of testing an apparatus for faults, the apparatus comprising a substrate, an integrated circuit region formed in the substrate; a seal ring disposed in the substrate to form a ring around the integrated circuit region; a first defect sensor structure comprising a first conductive track formed in the substrate, the first conductive track arranged to extend along a first edge of the substrate and disposed between the integrated circuit region and the seal ring wherein the first conductive track comprises: a first upper conductive track part formed in the substrate; a first lower conductive track part formed in the substrate below the first upper conductive track part; and a first connecting track which electrically connects the first upper conductive track part to the first lower conductive track part, and the first defect sensor structure further comprises: a first terminal coupled to the first upper conductive track part; and a second terminal coupled to the first lower conductive track part. The testing comprises; applying 401 the detection signal to one of the first terminal and the second terminal; determining 402 the absence of a fault along the first conductive track based on the electrical continuity of the first conductive track; and determining 403 the presence of a fault along the first conductive track based on a lack of electrical continuity of the first conductive track. Thus, a detection signal comprising a current applied at one terminal that is received at the other terminal is indicative of electrical continuity. If no current flows (or a flow of current below a threshold) then this is indicative of an absence of electrical continuity. It will be appreciated that, where a detection signal is applied to a driving terminal and there is no electrical continuity between the driving terminal and the receiving terminal, the detection signal (which comprises a current in the presence of electrical continuity) will not pass through the conductive track to the receiving terminal.

Where a first defect sensor structure comprises a second conductive track formed in the substrate, the second conductive track arranged to extend along a second edge of the substrate, different to the first edge, and disposed between the integrated circuit region and the seal ring and wherein the second conductive track comprises: a second upper conductive track part formed in the substrate and having a first end and a second end; a second lower conductive track part formed in the substrate below the second upper conductive track part and having a first end and a second end; and a second connecting track arranged to electrical connect the second ends of the second upper conductive track part and the second lower conductive track part, wherein one of: the first terminal is coupled to the second upper conductive track part at the first end thereof and a third terminal, different to the second terminal, is coupled to the first end of the second lower conductive track part and wherein testing the apparatus comprises applying the detection signal to the first terminal; the second terminal is coupled to the second lower conductive track part at the first end thereof and the third terminal, different to the first terminal, is coupled to the first end of the second upper conductive track part and wherein testing the apparatus comprises applying the detection signal to the second terminal; and the first terminal is coupled to the second lower conductive track part at the first end thereof and the third terminal, different to the second terminal, is coupled to the first end of the second upper conductive track part and wherein testing the apparatus comprises applying the detection signal to the first terminal. The method may further comprise: determining the absence of a fault along the second conductive track based on the electrical continuity of the second conductive track; and determining the presence of a fault along the second conductive track based on a lack of electrical continuity of the second conductive track.

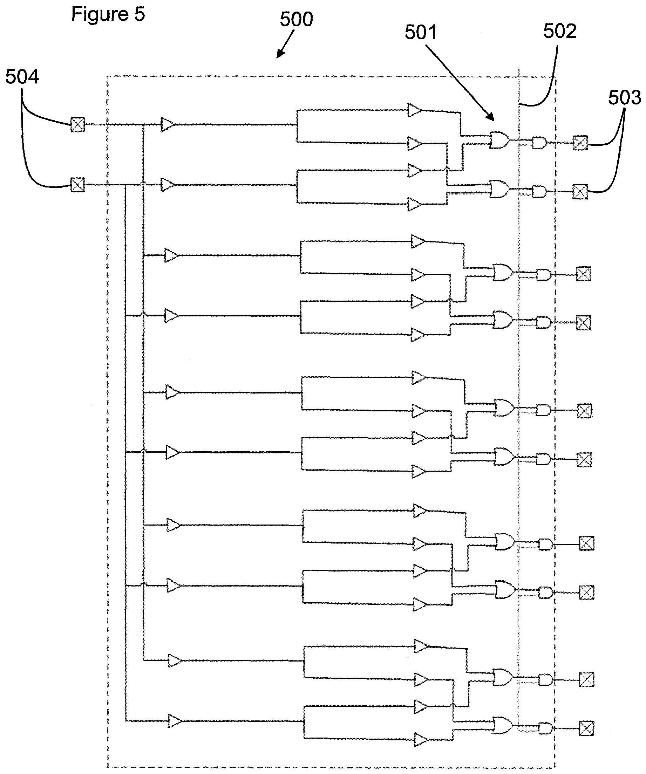

Figure 5 shows an example testing circuitry 500 comprising processing logic 501. It will be appreciated that the testing circuitry 500 (or other example thereof) may be located in the integrated circuit region 102 or may be located elsewhere on the substrate. A defect sense trigger signal may be applied to a defect sense trigger signal line 502 which provides for an output signal to be received at an output terminal 503. It will be appreciated that the processing logic may comprise any suitable combination of digital logic for determining the electrical continuity of the or each of the conductive tracks. In this example, exclusive OR (XOR) gates are provided each of which are coupled to first and second input terminals 504 and which may be connected to the receiving terminals of one or more defect sensor structures. AND gates are coupled to the outputs of the XOR gates and the defect sense trigger signal line 502. The testing circuitry may provide for output signals indicative of a defect causing damage to a conductive track.

It will be appreciated that references to first and second components or edges in this disclosure are not limiting thereon and are used for illustrative purposes only.

The instructions and/or flowchart steps in the above Figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus comprising:
a substrate;
an integrated circuit region formed in the substrate;
a seal ring disposed in the substrate to form a ring around the integrated circuit region;
a first defect sensor structure comprising a first conductive track formed in the substrate, the first conductive track arranged to extend along a first edge of the substrate and disposed between the integrated circuit region and the seal ring wherein the first conductive track comprises:
a first upper conductive track part formed in the substrate;
a first lower conductive track part formed in the substrate below the first upper conductive track part; and
a first connecting track arranged to electrically connect the first upper conductive track part to the first lower conductive track part,
and the first defect sensor structure further comprises:
a first terminal coupled to the first upper conductive track part; and
a second terminal coupled to the first lower conductive track part,
the first defect sensor structure configured to receive a detection signal therethrough between the first terminal and the second terminal to detect a break in the conductive track between said first and second terminals and thereby detect a defect in the substrate.

2. The apparatus of claim 1 wherein the first upper conductive track part and the first lower conductive track part each comprise a first end and a second end, wherein the first ends are located substantially adjacent one another and the second ends are located substantially adjacent one another, and wherein the first terminal is located at the first end of the first upper conductive track part and the second terminal is located at the first end of the lower conductive track part and the first connecting track is arranged to electrically connect the respective second ends.

3. The apparatus of claim 2 wherein the first defect sensor structure comprises a second conductive track formed in the substrate, the second conductive track arranged to extend along a second edge of the substrate, different to first edge, and disposed between the integrated circuit region and the seal ring wherein the second conductive track comprises:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part and the second lower conductive track part, wherein one of:
the first terminal is coupled to the second upper conductive track part at the first end thereof and a third terminal, different to the second terminal, is coupled to the first end of the second lower conductive track part; and
the second terminal is coupled to the second lower conductive track part at the first end thereof and the third terminal, different to the first terminal, is coupled to the first end of the second upper conductive track part;
the first terminal is coupled to the second lower conductive track part at the first end thereof and the third terminal, different to the second terminal, is coupled to the first end of the second upper conductive track part.

4. The apparatus of claim 3 wherein the third terminal is arranged in a group with the first and second terminals, wherein the first, second and third terminals are adjacent to one another.

5. The apparatus of any preceding claim wherein the first terminal is arranged substantially at a first corner of the substrate and the first connecting track is arranged substantially at a second corner of the substrate, different from the first corner, such that the first upper conductive track part extends along the first edge of the substrate between the first and second corners.

6. The apparatus of any preceding claim wherein the apparatus comprises at least a second defect sensor structure, the at least second defect sensor structure comprising at least a first conductive track formed in the substrate, the first conductive track of the at least second defect sensor structure arranged to extend along an edge of the substrate and disposed between the integrated circuit region and the seal ring wherein the first conductive track of the at least second defect sensor structure comprises:
a first upper conductive track part formed in the substrate and having a first end and a second end;
a first lower conductive track part formed in the substrate below the first upper conductive track part and having a first end and a second end; and
a first connecting track arranged to electrically connect the second ends of the first upper conductive track part to the first lower conductive track part,
and the at least second defect sensor structure further comprises:
a first terminal coupled to the first end of the first upper conductive track part; and
a second terminal coupled to the first end of the first lower conductive track part,
the at least second defect sensor structure configured to receive a detection signal therethrough between its first terminal and its second terminal to detect a break in the conductive track between said first and second terminals and thereby detect a defect in the substrate.

7. The apparatus of claim 6 wherein the second defect sensor structure further comprises a second conductive track formed in the substrate, the second conductive track arranged to extend along an edge of the substrate different to the edge along which the first conductive track of the second defect sensor structure extends, and disposed between the integrated circuit region and the seal ring wherein the second conductive track of the at least second defect sensor structure comprises:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part and the second lower conductive track part,
wherein one of:
the first terminal of the at least second defect sensor structure is coupled to the second upper conductive track part at the first end thereof and a third terminal, different to the second terminal, is coupled to the first end of the second lower conductive track part;
the second terminal of the at least second defect sensor structure is coupled to the second lower conductive track part at the first end thereof and the third terminal, different to the first terminal, is coupled to the first end of the second upper conductive track part; and
the first terminal of the at least second defect sensor structure is coupled to the second lower conductive track part at the first end thereof and the third terminal, different to the second terminal, is coupled to the first end of the second upper conductive track part.

8. The apparatus of claim 6 or claim 7 wherein the first conductive track of the second defect sensor structure is arranged to extend along the first edge of the substrate and the second defect sensor structure is vertically arranged in the substrate below the first defect sensor structure such that the first defect sensor structure and the second defect sensor structure form a vertical stack in the substrate.

9. The apparatus of claim 6 or claim 7 wherein the first conductive track of the second defect sensor structure is arranged to extend along a different portion of the first edge to the first conductive track, such that the position of a defect along the first edge of the substrate can be detected by the identification of which of the first defect sensor structure and the second defect sensor structure has detected a defect.

10. The apparatus of claims 6 or claim 7 wherein first conductive track of the second defect sensor structure extends along a third edge of the substrate different to the first edge or the second edge of the substrate.

11. The apparatus of claim 7 wherein the first terminal of the first defect sensor structure is located at a different corner of the substrate to the first terminal of the second defect sensor structure.

12. The apparatus of claim 7, wherein the first defect sensor structure and the second defect sensor structure are arranged such that the first and second conductive tracks of the first and second defect sensor structures extend along different edges of the substrate to one another.

13. The apparatus of any preceding claim wherein the substrate is a wafer and at least the integrated circuit region, the seal ring and the first defect sensor structure provide a semiconductor arrangement formed in the substrate and wherein the substrate comprises a plurality of such semiconductor arrangements, each of the plurality of semiconductor arrangements spaced from one another, and wherein, for each semiconductor arrangement, the edges of the substrate refer to the edge portions of the substrate bounded by the seal ring of the respective semiconductor arrangement.

14. A method of testing an apparatus for faults, the apparatus comprising:
a substrate;
an integrated circuit region formed in the substrate;
a seal ring disposed in the substrate to form a ring around the integrated circuit region;
a first defect sensor structure comprising a first conductive track formed in the substrate, the first conductive track arranged to extend along a first edge of the substrate and disposed between the integrated circuit region and the seal ring wherein the first conductive track comprises:
a first upper conductive track part formed in the substrate;
a first lower conductive track part formed in the substrate below the first upper conductive track part; and
a first connecting track which electrically connects the first upper conductive track part to the first lower conductive track part,
and the first defect sensor structure further comprises:
a first terminal coupled to the first upper conductive track part; and
a second terminal coupled to the first lower conductive track part,
and wherein testing comprises:
applying the detection signal to one of the first terminal and the second terminal;
determining the absence of a fault along the first conductive track based on the electrical continuity of the first conductive track; and
determining the presence of a fault along the first conductive track based on a lack of electrical continuity of the first conductive track.

15. The method of claim 14 wherein the first upper conductive track part and the first lower conductive track part each comprise a first end and a second end, wherein the first ends are located substantially adjacent to one another and the second ends are located substantially adjacent one another, and wherein the first terminal is located at the first end of the first upper conductive track part and the second terminal is located at the first end of the lower conductive track part and the second terminal is located at the first end of the lower conductive track part and the first connecting track is arranged to electrically connect the respective second ends and wherein the first defect sensor structure further comprises:
a second conductive track formed in the substrate, the second conductive track arranged to extend along a second edge of the substrate, different to first edge, and disposed between the integrated circuit region and the seal ring wherein the second conductive track comprises:
a second upper conductive track part formed in the substrate and having a first end and a second end;
a second lower conductive track part formed in the substrate below the second upper conductive track part and having a first end and a second end; and
a second connecting track arranged to electrically connect the second ends of the second upper conductive track part and the second lower conductive track part,
wherein one of:
the first terminal is coupled to the second upper conductive track part at the first end thereof and a third terminal, different to the second terminal, is coupled to the first end of the second lower conductive track part and wherein testing the apparatus comprises applying the detection signal to the first terminal;
the second terminal is coupled to the second lower conductive track part at the first end thereof and the third terminal, different to the first terminal, is coupled to the first end of the second upper conductive track part and wherein testing the apparatus comprises applying the detection signal to the second terminal; and
the first terminal is coupled to the second lower conductive track part at the first end thereof and the third terminal, different to the second terminal, is coupled to the first end of the second upper conductive track part and wherein testing the apparatus comprises applying the detection signal to the first terminal, and
testing the apparatus further comprises:
determining the absence of a fault along the second conductive track based on the electrical continuity of the second conductive track, and
determining the presence of a fault along the second conductive track based on a lack of electrical continuity of the second conductive track.
